# EUROPEAN PATENT APPLICATION

(11) **EP 2 369 411 A1**
(43) Date of publication of application: **28.09.2011**
(21) Application number: 10172055.5
(22) Date of filing: 05.08.2010
(51) Int. Cl.: G03B 21/16, G03B 21/20, H01L 23/427

(54) **Light source module and display apparatus having the same**

(30) Priority: 22.03.2010 KR 20100025427
(71) Applicant: Samsung Electronics Co., Ltd., Gyeonggi-do 442-742 (KR)
(72) Inventor: Park, Jae-hyun, Seoul (KR); Nho, Jeong-ho, Gyeonggi-do (KR); Lim, Nam-gyu, Gyeonggi-do (KR); Kim, Sung-tae, Seoul (KR)
(74) Representative: Robinson, Ian Michael

(57) **Abstract**

A display apparatus and a light source module are provided. The display apparatus includes: a display unit; and a light source module providing light so that an image is displayed on the display unit, the light source module including: a light emitting element which emits the light; a base substrate on which the light emitting element; and a cooling unit including: a capillary tube forming part which a capillary tube inside the base substrate and extending between a first area and a second area farther away from the light emitting element than the first area, and coolant which travels between the first area and the second area in the capillary tube according to a change in phase caused by heat from the light emitting element to transfer the heat from the first area to the second area, and which cools the emitted heat.

## Description

### BACKGROUND

### Field

Apparatuses consistent with exemplary embodiments relate to a light source module which generates and emits light to display an image and a display apparatus having the same, and more particularly, to a light source module which has a structure of cooling heat generated from a light source generating light and a display apparatus having the same.

### Description of the Related Art

A display apparatus is a device which processes an image signal input from an outside source to display an image. An image display structure of a display apparatus may be designed in various ways. For example, a display apparatus may include a display panel realized as a liquid crystal panel and processes an image to be displayed thereon. Alternatively, a display apparatus may be a projection type in which an image formed on a display panel is projected by a variety of lenses onto a large screen to realize a large-scale image.

Such display apparatuses include a light source which generates and emits light to display an image. The light source generates light when voltage with a certain level is applied thereto, and the applied voltage is converted into both light and heat. Thus, various heat radiation and cooling structures for the display apparatus have been proposed to cool heat generated in the light source.

Examples of related art cooling methods include installation of a heat pipe and a heat sink on a substrate on which a light source is mounted to discharge heat generated in the light source through the substrate, the heat pipe and the heat sink, ventilation cooling of a light source by a ventilation fan, and the like.

### SUMMARY

According to the present invention there is provided an apparatus and method as set forth in the appended claims. Other features of the invention will be apparent from the dependent claims, and the description which follows.

One or more exemplary embodiments provide a display device.

According to an aspect of an exemplary embodiment, there is provided a display apparatus including: a display unit; and a light source module which provides light to the display unit to display the image, the light source module including: at least one light emitting element which emits the light; a base substrate on which the light emitting element is mounted; and a cooling unit including a capillary tube forming part which forms a capillary tube inside of the base substrate and extending between a first area and a second area farther away from the light emitting element than the first area, and coolant which travels between the first area and the second area in the capillary tube according to a change in phase caused by heat emitted by the light emitting element to transfer the emitted heat from the first area to the second area, and which cools the heat of the light emitting element.

The coolant may be vaporized by heat absorption in the first area to travel to the second area and may be liquefied by heat emission in the second area to travel to the first area.

The capillary tube may extend in at least one second direction substantially perpendicular to a first direction which extends between the first area and the second area.

The cooling unit may include at least one groove extending in the first direction in the capillary tube.

The cooling unit may include at least one heat discharge part disposed at an end portion of the capillary tube to discharge the emitted heat to an outside of the base substrate.

The base substrate may include a metal material.

The light emitting element may include a light emitting diode.

The display apparatus may further include: an image receiver which receives an image signal; and an image processor which processes the received image signal to be displayed on the display unit.

According to an aspect of another exemplary embodiment, there is provided a light source module of a display apparatus including: at least one light emitting element which emits light; a base substrate on which the light emitting element is mounted; and a cooling unit including a capillary tube forming part which forms a capillary tube inside of the base substrate and which extends between a first area and a second area more farther away from the light emitting element than the first area, and coolant which travels between the first area and the second area in the capillary tube according to a change in phase caused by heat emitted by the light emitting element to transfer the emitted heat from the first area to the second area, and cools the emitted heat of the light emitting element.

The coolant may be vaporized by heat absorption in the first area to travel to the second area and may be liquefied by heat emission in the second area to travel to the first area.

The capillary tube may extend in at least one second direction substantially perpendicular to a first direction which extends between the first area and the second area.

The cooling unit may include at least one groove extending in the first direction in the capillary tube.

The cooling unit may include at least one heat discharge part disposed at an end portion of the capillary tube extending in the second direction to discharge the emitted heat to an outside of the base substrate.

The base substrate may include a metal material.

The light emitting element may include a light emitting diode.

According to an aspect of another exemplary embodiment, there is provided a cooling unit supporting a light emitting element which emits a light to a display apparatus, the cooling unit including: a capillary tube which extends between a first area and a second area farther away from the light emitting element than the first area; and coolant which travels between the first area and the second area in the capillary tube according to a change in phase caused by heat emitted by the light emitting element to transfer the emitted heat from the first area to the second area, and which cools the heat emitted from the light emitting element.

### BRIEF DESCRIPTION OF THE DRAWINGS

The above and/or other aspects will become apparent and more readily appreciated from the following description of exemplary embodiments, taken in conjunction with the accompanying drawings, in which:

FIG. 1 schematically shows an illustrative example of a display apparatus according to an exemplary embodiment;

FIG. 2 is a perspective view of a main part of a light source module according to an exemplary embodiment;

FIG. 3 is a lateral cross-sectional view of a main part of a light source module according to an exemplary embodiment;

FIG. 4 is a perspective view of an inside structure of a base substrate of a light source module according to an exemplary embodiment;

FIGs. 5A to 5D illustrate various non-limiting examples of capillary tubes formed in a light source module according to various exemplary embodiments;

FIG. 6 is a perspective view of an assembly of a display apparatus according to an exemplary embodiment; and

FIG. 7 is a block diagram of a display apparatus according to an exemplary embodiment.

### DETAILED DESCRIPTION OF EXEMPLARY EMBODIMENTS

Below, exemplary embodiments will be described in detail with reference to accompanying drawings so as to be easily realized by a person having ordinary knowledge in the art. The exemplary embodiments may be embodied in various forms without being limited to the exemplary embodiments set forth herein. Descriptions of well-known parts are omitted for clarity, and like reference numerals refer to like elements throughout. Expressions such as "at least one of," when preceding a list of elements, modify the entire list of elements and do not modify the individual elements of the list.

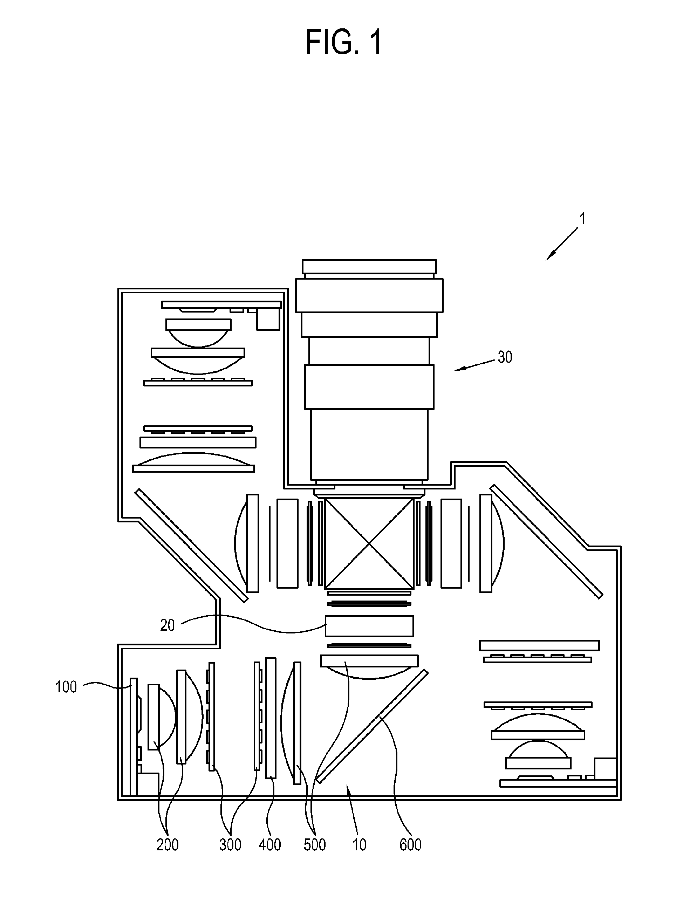

FIG. 1 is a plan view illustrating an optical arrangement of a display apparatus 1 according to an exemplary embodiment. As shown in FIG. 1, the display apparatus 1 is implemented as a projection type and includes an illumination optical unit 10 which emits light, a display unit 20 which forms an image on the basis of light emitted from the illumination optical unit 10 and a projection optical unit 30 which enlarges and projects an image formed in the display unit 20 on an external screen (not shown).

A plurality of illumination optical units 10 and a plurality of display units 20 respectively corresponding to a plurality of colors, e.g., red, green and blue (RGB) colors, are disposed in the display apparatus 1. Furthermore, and images formed by the plurality of colors are overlapped and projected by the projection optical unit 30. Though the present exemplary embodiment is explained with reference to one illumination optical unit 10 and one display unit 20 corresponding to any single color, it is understood that other of the illumination optical units 10 and display units 20 have a same or similar construction as those respectively described herein, and therefore descriptions thereof are omitted.

The illumination optical unit 10 includes a light source module 100 which generates light, a light parallelizing unit 200 which adjusts light emitted from the light source module 100 into parallel light, a uniformizing unit 300 which uniformizes light exiting from the light parallelizing unit 200, a polarization conversion unit 400 which converts light exiting from the uniformizing unit 300 into light with predetermined polarization properties, a condensing unit 500 which collects light exiting from the polarization conversion unit 400 and which transmits the collected light to the display unit 20, and a reflection mirror 600 which changes a path of the light into a certain direction.

The respective components of the illumination optical unit 10 which convert properties of incident light and transmit the converted light may be provided as a lens, and a plurality of lenses may be disposed along a path of the light in order to correct aberrations.

The display unit 20 selectively transmits or reflects light emitted from the illumination optical unit 10 to form an image. The display unit 20 may be realized as a digital micromirror device (DMD), which selectively reflects incident light by pixel to form an image, a reflective display device such as a liquid crystal on silicon (LCOS) device, and a transmissive liquid crystal display (LCD), which selectively transmits incident light by pixel to form an image.

For example, if the display unit 20 is provided as a liquid crystal panel such as an LCOS device and a transmissive LCD, light entering the display unit 20 is to be adjusted to have preset polarization properties. Thus, polarization properties of the light are adjusted by the polarization conversion unit 400 before the light reaches the display unit 20.

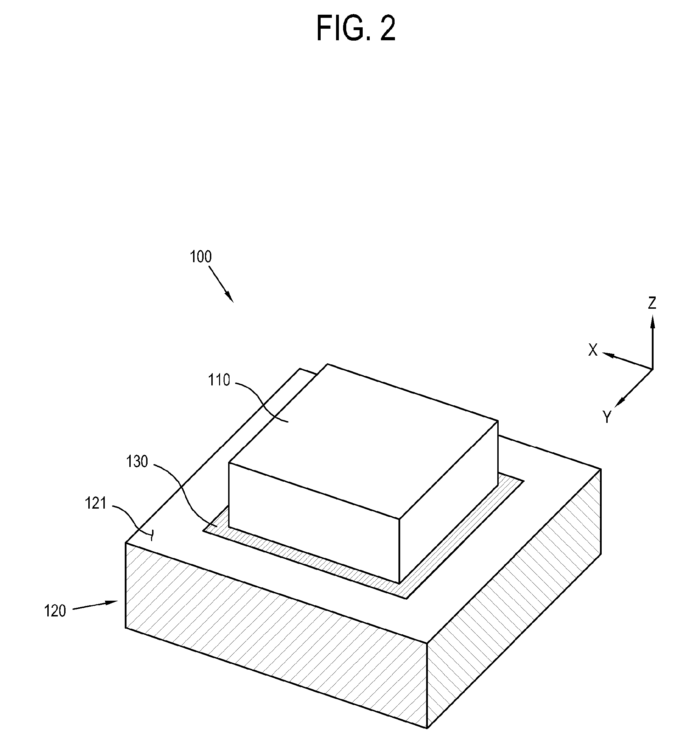

With the foregoing exemplary configuration, the light source module 100 generates heat along with light as voltage is applied to generate the light. However, according to the present exemplary embodiment, a cooling structure of the light source module 100 releases and cools heat generated therein, as described below with reference to FIG. 2.

FIG. 2 is a perspective view of a main part of a light source module 100 according to an exemplary embodiment. In the present disclosure, for purposes of clarity, X, Y and Z directions, which are perpendicular to one another, respectively indicate width, length and height directions. Moreover, in the present exemplary embodiment, light generated in the light source module 100 is emitted in the Z direction. Furthermore, for purposes of clarity in the present disclosure, the opposite X, Y and Z directions are respectively expressed as -X, -Y and - Z directions, and the XY-plane refers to a plane defined by the X-axis and the Y-axis.

As shown in FIG. 2, the light source module 100 includes a light emitting element 110 which generates light, a base substrate 120 on which the light emitting element 110 is mounted supported, and a driving circuit 130 which is printed on an upper surface 121 of the base substrate 120 on which the light emitting element 110 is mounted.

The light emitting element 110 generates light by voltage applied through the driving circuit 130. For example, the light emitting element 110 may be a light emitting diode (LED), a fluorescent lamp (such as a cold cathode fluorescent lamp), etc. The light emitting element 110 converts the applied voltage into light, and generates heat along with the light according to light conversion efficiency properties. The heat generated in the light emitting element 110 may deteriorate operation of the light emitting element 110 and the driving circuit 130.

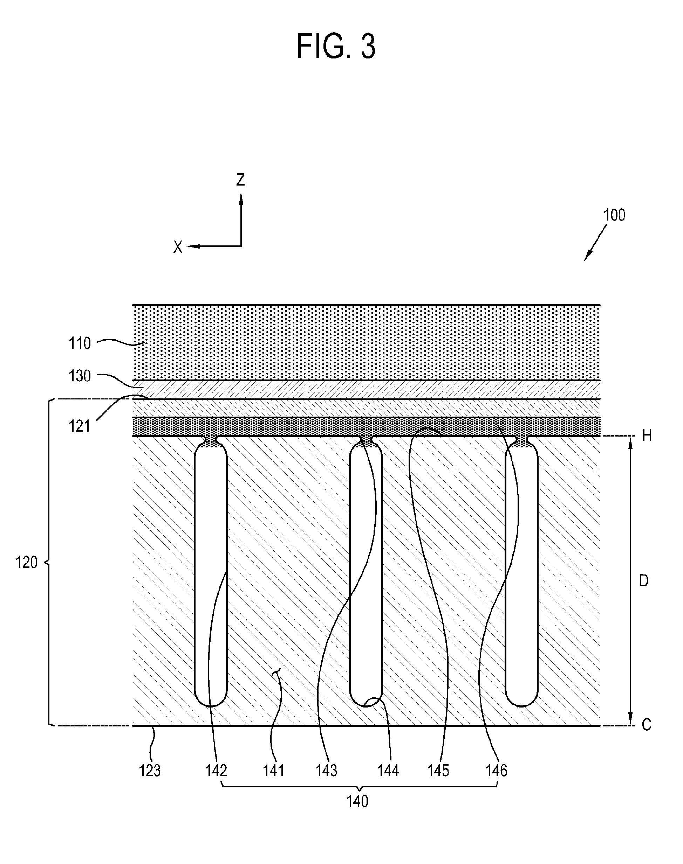

However, the light source module 100 according to the present exemplary embodiment employs a cooling unit (not shown) which transfers and releases the heat from the light emitting element 110 to cool the light emitting element 110. Such a cooling unit (not shown) will now be explained in detail with reference to FIG. 3.

FIG. 3 is a lateral cross-sectional view of a main part of a light source module 100 according to an exemplary embodiment. As shown in FIG. 3, the light source module 100 includes a cooling unit 140 disposed in the base substrate 120 in order to cool heat generated in the light emitting element 110.

The cooling unit 140 includes a capillary tube forming part 141 which forms a structure of a capillary tube 142 extending between a first area (H) adjacent to the light emitting element 110 and a second area (C) farther away from the light emitting element 110 than the first area (H) in the base substrate 120. Furthermore, the cooling unit 140 includes coolant 146 traveling in the capillary tubes 142 according to a phase change due to heat from the light emitting element 110 to transfer the heat of the light emitting element 110 from the first area (H) to the second area (C).

Thus, the cooling unit 140 according to the present exemplary embodiment reduces space involved in cooling the light emitting element 110 and does not use a power source thereby saving energy as compared to related art components such as a heat pipe, a heat sink and a ventilating fan.

Hereinafter, a detailed configuration of the cooling unit 140 will now be described. The capillary tube forming part 141 supports the base substrate 120 and forms the capillary tube 142 in the base substrate 120. The capillary tube forming part 141 may include a metal material having heat transfer efficiency and rigidity, and may be formed of the same material as the base substrate 120 in a single body or may be formed of a different material and connected to the base substrate 120.

The capillary tube 142 is provided in the base substrate 120 by an empty area of the capillary tube forming part 141. The capillary tube 142 extends between the first area (H) which is adjacent to the light emitting element 110 and heated by the light emitting element 110 and the second area (C) farther away from the light emitting element 110 than the first area (H).

The first area (H) and the second area (C) may be set variously when designing the light source module 100. That is, relative arrangement positions of the first area (H) and the second area (C), a distance therebetween, arrangement directions thereof, etc., may vary in various exemplary embodiments. According to the present exemplary embodiment, the first area (H) is an area inside the base substrate 120 adjacent to the upper surface 121 of the base substrate 120 on which the light emitting element 110 is mounted, and the second area (C) is an area inside the base substrate 120 adjacent to a lower surface 123 of the base substrate 120.

As described above, the capillary tube 142 extends from the first area (H) to the second area (C). The capillary tube 142 has an opening 143 connected to a coolant accommodating unit 145 disposed in the first area (H) to accommodate the coolant 146. The capillary tube 142 extends from the opening 143 in the -Z direction and has an end portion 144 positioned in the second area (C). Although the capillary tube 142 of the present exemplary embodiment extends vertically in the -Z direction, it is understood that other exemplary embodiments are not limited thereto. For example, the capillary tube 142 may extend at a certain angle with respect to the Z-axis or extend along a bent or curved line according to other exemplary embodiments.

The coolant 146 may be water or a liquid with a low evaporation point. The coolant 146 is accommodated in the coolant accommodating unit 145 and may travel in the capillary tube 142 through the opening 143. The coolant 146 changes in phase (e.g., vaporization and liquefaction) at a certain boiling point corresponding to heat absorption or emission. The coolant 146 has a boiling point which may be determined according to properties of the light source module 100, and is not limited to a specific value in other exemplary embodiments.

An exemplary operation of the cooling unit 140 cooling heat of the light emitting element 110 will now be described. When voltage is applied to the light emitting element 110 through the driving circuit 130, the light emitting element 110 generates light. As a result, heat is emitted from the light emitting element 110. The heat emitted from the light emitting element 110 is transmitted to the first area (H) from the upper surface 121 of the base substrate 120 on which the light emitting element 110 is mounted.

The coolant 146 accommodated in the coolant accommodating unit 145 absorbs the heat transmitted to the first area (H). The coolant 146 is vaporized as the coolant 146 absorbs the heat and the vaporized coolant 146 enters the capillary tube 142 through the opening 143 to travel along the capillary tube 142 in the -Z direction.

The coolant 146 vaporized via the endothermic reaction travels in the -Z direction to reach the second area (C). Since the second area (C) is spaced away from the light emitting element 110 at a distance of D as compared with the first area (H), the second area (C) has a relatively low temperature in comparison with the first area (H). Thus, the coolant 146 undergoes an exothermic reaction in the second area (C) and is liquefied while emitting heat.

According to the above process, the heat of the light emitting element 110 is transferred from the first area (H) to the second area (C) to release the heat of the light emitting element 110, thereby cooling the light emitting element 110.

Meanwhile, the liquefied coolant 146 travels from the second area (C) to the first area (H) along the capillary tube 142 to the coolant accommodating unit 145 due to, for example, capillarity or cohesiveness of a liquid and attraction of a liquid to a tube. Capillarity refers to a phenomenon by which, where a capillary tube is placed in a liquid, a surface of the liquid in the tube becomes higher than or lower than the liquid outside the tube. Capillarity is a known physical phenomenon, and thus a description thereof is omitted herein.

Through repetition of the foregoing process, the coolant 146 travels between the first area (H) and the second area (C) along the capillary tube 142 while changing in phase, thereby cooling the emitted heat of the light emitting element 110.

The cooling unit 140 according to the present exemplary embodiment reduces space used for a cooling component of the light emitting element 110 as compared with a related art heat pipe and a related art heat sink to cool the light emitting element 110. Furthermore, the cooling unit 140 according to the present exemplary embodiment enables cooling without an additional driving force, unlike a related art ventilating fan.

Meanwhile, although the cooling unit 140 according to the present exemplary embodiment includes the coolant accommodating unit 145 disposed in the first area (H), it is understood that the coolant accommodating unit 145 may be omitted in one or more other exemplary embodiments. For example, the coolant 146 may be accommodated in the capillary tube 142 according to another exemplary embodiment. In this case, the coolant 146 travels between the first area (H) and the second area (C) in the capillary tube 142 while changing in phase. Accordingly, heat emitted from the light emitting element 110 is transferred from the first area (H) to the second area (C).

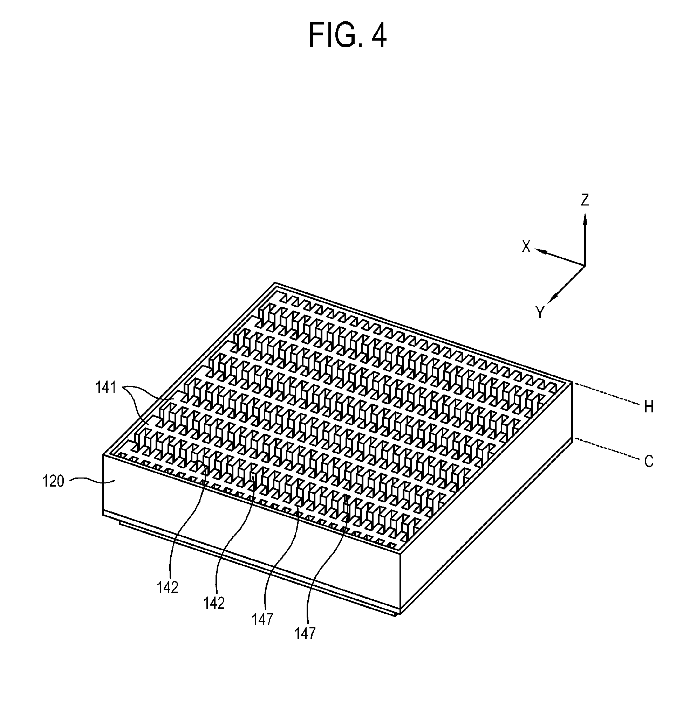

FIG. 4 is a perspective view of an inside structure of a base substrate 120 of a light source module 100 according to an exemplary embodiment. FIG. 4 shows the inside of the base substrate 120 with the upper surface 121 removed from the base substrate 120 (such as the base substrate 120 illustrated in FIG. 2).

Referring to FIG. 4, the capillary tube 142 extends in the -Z direction as described above, such that the coolant 146 travels in the Z and -Z directions to transfer heat.

Additionally, the capillary tube 142 extends in a direction parallel with the X-Y plane, which is perpendicular to the -Z direction, i.e., the X direction in FIG. 4. Heat emitted from the light emitting element 110 is transferred in the -Z direction by the coolant 146 moving in the Z direction and -Z direction and additionally in the X and -X directions in the capillary tube 142.

That is, the capillary tube 142 extends in the -Z direction for phase-change movement of the coolant 146 and also in a direction substantially perpendicular to the -Z direction, thereby transferring heat along various directional paths.

Furthermore, though the capillary tube 142 according to the present exemplary embodiment extends in the X direction in addition to the Z direction, it is understood that one or more other exemplary embodiments are not limited thereto. For example, according to another exemplary embodiment, the capillary tube 142 may extend in a direction parallel with a sloping plane at a certain angle relative to the Z direction.

Meanwhile, the capillary tube 142 includes at least one groove 147 therein. The groove 147 extends in the -Z direction from the first area (H) to the second area (C), i.e., the groove 147 extends in a direction in which the coolant 146 changing in phase due to heat emitted from the light emitting element 110 travels. The groove 147 improves surface tension of the coolant 146 in the capillary tube 142, allowing the coolant 146 to travel smoothly between the first area (H) and the second area (C).

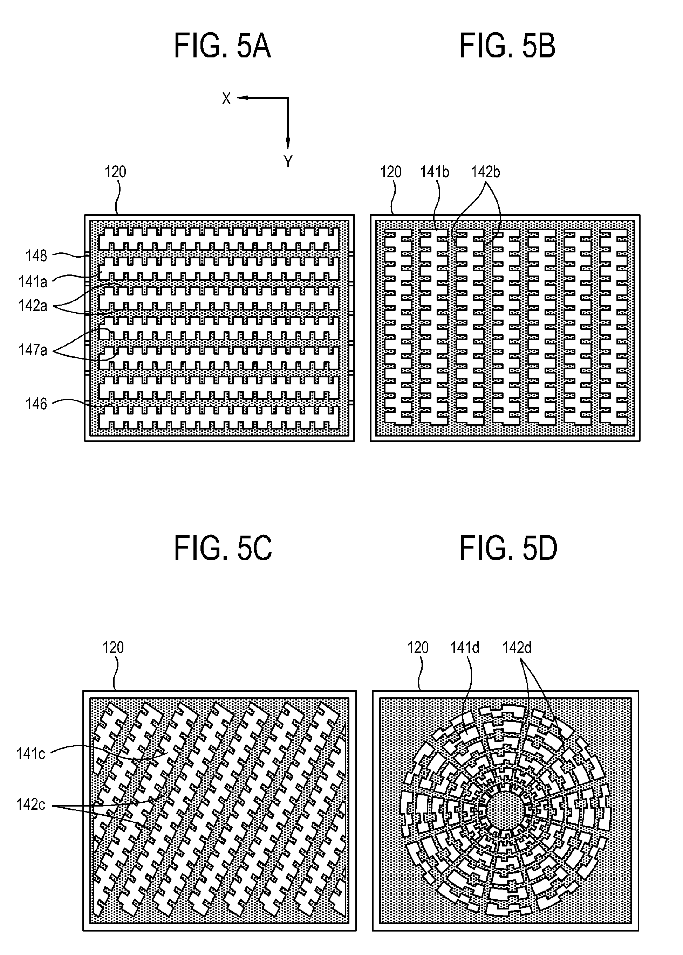

An extending direction of the capillary tube 142 in FIG. 4 may vary in one or more other exemplary embodiments. Examples of capillary tubes 142 extending in various directions parallel with the X-Y plane will now be explained with reference to FIGs. 5A to 5D. FIGs. 5A to 5D illustrate four non-limiting examples of extending directions of the capillary tube 142.

FIG. 5A illustrates a capillary tube 142a according to an exemplary embodiment, which extends parallel to the X-axis according to a capillary tube forming part 141a in the base substrate 142. A groove 147a is formed in the capillary tube 142a in a direction parallel with the Y-axis and substantially perpendicular to the extending direction of the capillary tube 142a. According to the present exemplary embodiment, heat of the light emitting element 110 is transferred in the X or -X direction through the coolant 146, and a heat discharge part 148 is disposed on an edge in the X or -X direction of the base substrate 120 to discharge heat transferred to the edge of the base substrate 120.

The heat discharge part 128 is not limited to a specific type and is capable of discharging heat to an outside of the base substrate 120. The heat discharge part 128 may have various configurations in various exemplary embodiments. Furthermore, the heat discharge part 128 may include, for example, material with relatively high heat conductivity, as compared to the base substrate 120.

Furthermore, in another exemplary embodiment, a separate heat discharge part 128 may not be provided. Rather, heat may be discharged according to heat conduction properties of the base substrate 120.

FIG. 5B illustrates a capillary tube 142b according to an exemplary embodiment, which extends in a direction parallel to the Y-axis according to a capillary tube forming part 141b. In this case, heat of the light emitting element 110 is transferred in the Y or -Y direction.

FIG. 5C illustrates a capillary tube 142c according to an exemplary embodiment, which extends at an incline, according to a capillary tube forming part 141c, at a certain angle with respect to the X-axis and the Y-axis, respectively. In this case, heat of the light emitting element 110 is transferred in a direction inclined along the X-axis and the Y-axis, respectively.

FIG. 5D illustrates a capillary tube 142d according to an exemplary embodiment, which extends parallel to the X-Y plane in every direction according to a capillary tube forming part 141d. In this case, heat of the light emitting element 110 is transferred in every direction, thereby improving heat transfer efficiency as compared with the foregoing exemplary embodiment.

As illustrated with the above examples, an extending direction of the capillary tube 142 for heat transfer may vary in various exemplary embodiments.

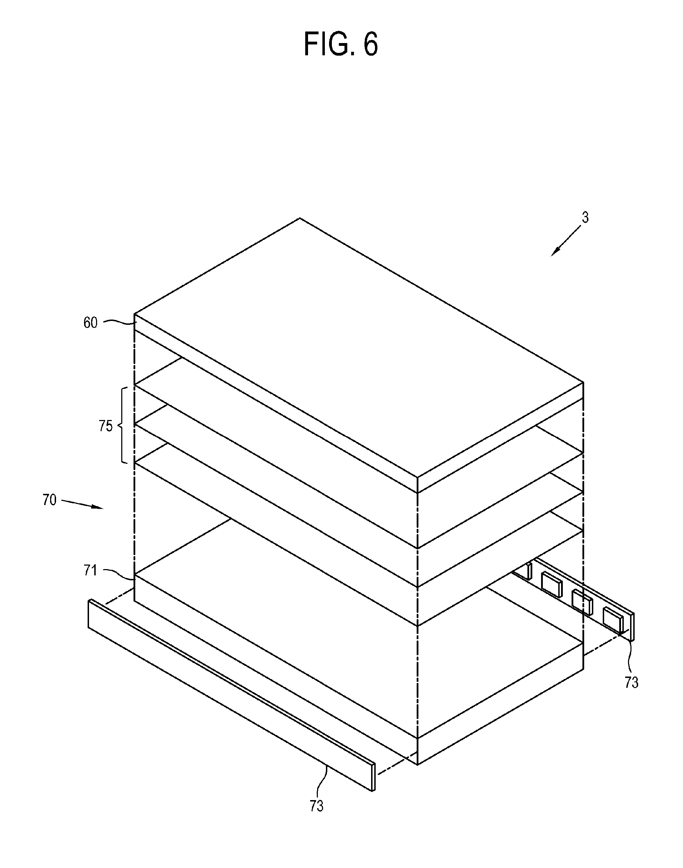

Meanwhile, although the foregoing exemplary embodiments have been described with reference to a projection-type display apparatus 1, it is understood that aspects are not limited thereto. For example, the cooling unit 140 according to another exemplary embodiment may be applicable to other types of display apparatuses, e.g., to a backlight unit 70 of a liquid crystal display 3, which will now be described with reference to FIG. 6.

FIG. 6 is a perspective view of an assembly of a display apparatus 3 according to an exemplary embodiment. As shown in FIG. 6, the display apparatus 3 includes a display panel 60 on which an image is displayed and a backlight unit 70 which provides light to the display panel 60 so that the image is displayed on the display panel 60.

The display panel 60 may, for example, be realized as a liquid display panel. In this case, the display panel 60 includes a liquid crystal layer (not shown) disposed between two substrates (not shown) and displays an image by applying a driving signal to adjust alignments of liquid crystals in the liquid crystal layer (not shown). The display panel 60 is provided with light from the backlight unit 70 to display the image in a display region.

The display panel 60 includes a driving circuit board (not shown). When a driving signal is applied from the driving circuit board, liquid crystals (not shown) of the display panel 60 rotate at a certain angle. Accordingly, light transmittance characteristics become different in each cell (not shown) forming the display region of the display panel 60, so that the image is displayed in the display region.

The backlight unit 70 is disposed behind or under the display panel 60 to provide light to the display panel 60. The backlight unit 70 includes a light guide plate 71 which guides the light to the display region of the display panel 60, a light source module 73 which emits the light to a lateral side of the light guide plate 71, and optical sheets 75 which adjust characteristics of the light exiting from the light guide plate 71.

As an example, the light guide plate 71 may be a plastic lens realized by acryl injection molding. The light guide plate 71 uniformly transmits the light incident from the light source module 73 to the entire display region of the display panel 60. The light guide plate 71 has a light guide plate pattern or optical pattern on a lower surface to diffuse the light, thereby improving uniformity of the light exiting from the light guide plate 71 and adjusting an amount of the exiting light.

The light source module 73 generates the light to be provided to the display panel 60. The light source module 73 has a same or similar configuration as the aforementioned light source module 100 described above with reference to FIG. 1, and a description thereof is therefore omitted herein.

At least one optical sheet 75 is layered on a rear side of the display panel 60 parallel with the display panel 60. The at least one optical sheet 75 may include at least one of a prism sheet, a diffusion sheet, a protection sheet, etc., and adjusts characteristics of the light exiting from the light guide plate 71 to be transmitted to the display panel 60.

Although the backlight unit 70 according to the present exemplary embodiment is an edge-type backlight unit in which the light source module 73 is disposed on an edge of the light guide plate 71, it is understood that other exemplary embodiments are not limited thereto. For example, according to other exemplary embodiments, the backlight unit 70 may be a direct-type backlight unit in which a light source module is disposed at rear of a light guide plate or a backlight unit in which a light source module is disposed between a divided light guide plate.

Moreover, examples of the display apparatuses 1 and 3 according to the aforementioned exemplary embodiments include a television (TV), a monitor, etc...

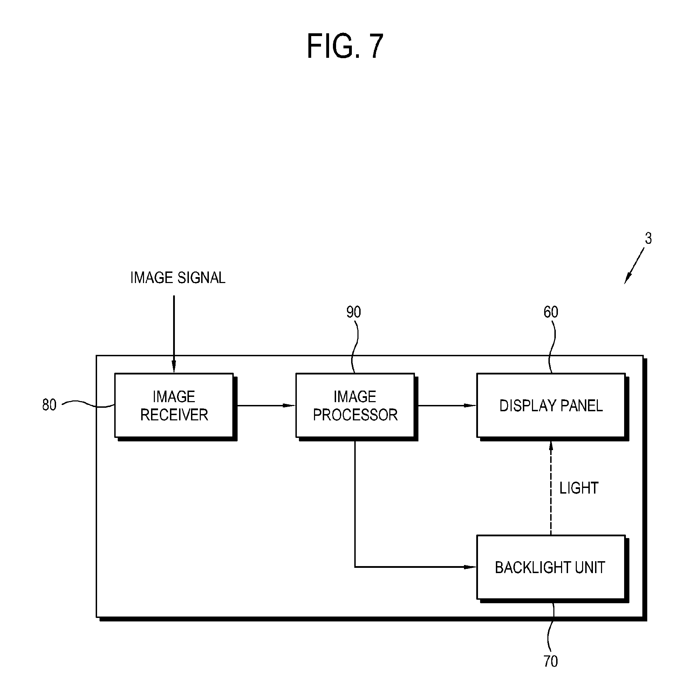

FIG. 7 is a block diagram of a display apparatus 3 according to an exemplary embodiment. As shown in FIG. 7, the display apparatus 3 includes an image receiver 80 which receives an image signal, an image processor 90 which processes the image signal received by the image receiver 80, a display panel 60 which displays an image according to the image signal processed by the image processor 90, and a backlight unit 70 which provides light to the display panel 60 to display the image.

The image receiver 80 may receive the image signal via various communication methods. For example, , the image receiver 80 may receive a radio frequency (RF) signal transmitted from a broadcasting station (not shown) wirelessly or by wire. Furthermore, the image receiver 80 may receive the image signal according to at least one of composite video, component video, super video, SCART, and high definition multimedia interface (HDMI) standards. Moreover, the image receiver 80 may receive the image signal via a D-submarine (D-SUB) connector that transmits RGB signals according to the Video Graphics Array (VGA) format or may receive the image signal according to the digital video interactive (DVI) standard.

The image processor 90 performs one or more image processing processes on the image signal transmitted from the image receiver 80. For example, the image processor 80 may perform at least one of decoding and encoding corresponding to various image formats, de-interlacing, frame refresh rate conversion, scaling, noise reduction to improve image quality, detail enhancement, etc. The image processor 90 may be provided as a separate component to independently conduct each process or may be provided as an integrated component which is multifunctional.

The display panel 60 and the backlight unit 70 have the same or similar configuration as those described above with reference to FIG. 6, and therefore descriptions thereof are omitted herein.

Although a few preferred embodiments have been shown and described, it will be appreciated by those skilled in the art that various changes and modifications might be made without departing from the scope of the invention, as defined in the appended claims.

## Claims

1. A display apparatus comprising:
a display unit which displays an image; and
a light source module which provides light to the display unit to display the image, the light source module comprising:
at least one light emitting element which emits the light,
a base substrate on which the light emitting element is mounted , and
a cooling unit comprising a capillary tube forming part which forms a capillary tube inside of the base substrate and which extends between a first area and a second area farther away from the light emitting element than the first area, and coolant which travels between the first area and the second area in the capillary tube according to a change in phase caused by heat emitted by the light emitting element to transfer the emitted heat from the first area to the second area, and which cools the heat emitted from the light emitting element.

2. The display apparatus according to claim 1, wherein the coolant is vaporized by heat absorption in the first area to travel to the second area and is liquefied by heat emission in the second area to travel to the first area.

3. The display apparatus according to claim 1 or 2, wherein the capillary tube extends in at least one second direction substantially perpendicular to a first direction which extends between the first area and the second area.

4. The display apparatus according to claim 3, wherein the capillary tube comprises at least one groove extending in the first direction.

5. The display apparatus according to claim 3, wherein the cooling unit further comprises at least one heat discharge part disposed at an end portion of the capillary tube extending in the second direction and which discharges the emitted heat to an outside of the base substrate.

6. The display apparatus according to any preceding claim, wherein the base substrate comprises a metal material.

7. The display apparatus according to any preceding claim, wherein the light emitting element comprises a light emitting diode.

8. The display apparatus according to any preceding claim, further comprising:
an image receiver which receives an image signal corresponding to the image; and
an image processor which processes the received image signal to be displayed on the display unit.

9. A light source module of a display apparatus, the light source module comprising:
at least one light emitting element which emits light;
a base substrate on which the light emitting element is mounted; and
a cooling unit comprising:
a capillary tube forming part which forms a capillary tube inside of the base substrate and which extends between a first area and a second area farther away from the light emitting element than the first area, and
coolant which travels between the first area and the second area in the capillary tube according to a change in phase caused by heat emitted by the light emitting element to transfer the emitted heat from the first area to the second area, and which cools the emitted heat from the light emitting element.

10. The light source module according to claim 9, wherein the coolant is vaporized by heat absorption in the first area to travel to the second area and is liquefied by heat emission in the second area to travel to the first area.

11. The light source module according to claim 9, wherein the capillary tube extends in at least one second direction substantially perpendicular to a first direction which extends between the first area and the second area.

12. The light source module according to claim 11, wherein the capillary tube comprises at least one groove extending in the first direction.

13. The light source module according to claim 11, wherein the cooling unit further comprises at least one heat discharge part disposed at an end portion of the capillary tube extending in the second direction and which discharges the emitted heat to an outside of the base substrate.

14. The light source module according to claim 9, wherein the base substrate comprises a metal material.

15. The light source module according to claim 9, wherein the light emitting element comprises a light emitting diode.

## Amended claims

### Amended claims in accordance with Rule 137(2) EPC.

**1.** A light source module (100) of a display apparatus, the light source module (100) comprising:
at least one light emitting element (110) which emits light;
a base substrate (120) on which the light emitting element (110) is mounted; and
a cooling unit (140) comprising:
a capillary tube forming part (141) which forms a capillary tube (142) inside of the base substrate (120) and which extends between a first area (H) and a second area (C) farther away from the light emitting element (110) than the first area (H), and
**characterised in that** coolant (146) travels between the first area (H) and the second area (C) in the capillary tube (142) according to a change in phase caused by heat emitted by the light emitting element (110) to transfer the emitted heat from the first area (H) to the second area (C), and which cools the emitted heat from the light emitting element (110).

**2.** The light source module (100) according to claim 1, wherein the coolant (146) is vaporized by heat absorption in the first area (H) to travel to the second area (C) and is liquefied by heat emission in the second area (C) to travel to the first area (H).

**3.** The light source module according to claim 1 or 2, wherein the capillary tube (142) extends in at least one second direction (x,y) substantially perpendicular to a first direction (z) which extends between the first area (H) and the second area (C).

**4.** The light source module (100) according to claim 1, 2 or 3, wherein the capillary tube (142) comprises at least one groove (147) extending in the first direction (z).

**5.** The light source module (100) according to any of claims 1 to 4, wherein the cooling unit (140) further comprises at least one heat discharge part (148) disposed at an end portion of the capillary tube (142) extending in the second direction (x,y)and which discharges the emitted heat to an outside of the base substrate (120).

**6.** The light source module (100) according to any preceding claim, wherein the base substrate (120) comprises a metal material.

**7.** The light source module (100) according to any preceding claim, wherein the light emitting element (110) comprises a light emitting diode.

**8.** A display apparatus, comprising:
a display unit (60) which displays an image; and
a light source module (100) which provides light to the display unit (20) to display the image, wherein the light source module (100) is arranged as set forth in any preceding claim.

**9.** The display apparatus according to claim 8, further comprising:
an image receiver (80) which receives an image signal corresponding to the image; and
an image processor (90) which processes the received image signal to be displayed on the display unit (20).
